Europäisches Patentamt

European Patent Office

Office européen des brevets

(11) Numéro de publication : **0 461 999 B1**

(12) **FASCICULE DE BREVET EUROPEEN**

(45) Date de publication du fascicule du brevet :
16.02.94 Bulletin 94/07

(51) Int. Cl.⁵ : **G01R 33/26**

(21) Numéro de dépôt : **91401557.3**

(22) Date de dépôt : **12.06.91**

(54) **Magnétomètre à résonance et à pompage optique utilisant un faisceau lumineux à polarisation asservie.**

(30) Priorité : **14.06.90 FR 9007411**

(43) Date de publication de la demande :
**18.12.91 Bulletin 91/51**

(45) Mention de la délivrance du brevet :
**16.02.94 Bulletin 94/07**

(84) Etats contractants désignés :
**BE DE GB IT NL SE**

(56) Documents cités :
**EP-A- 0 246 146**
**DE-A- 2 624 717**
**FR-A- 1 354 208**
**US-A- 4 814 707**
**MESURES REGULATION AUTOMATISME. vol. 45, no. 12, décembre 1980, PARIS FR pages 69 - 72; R. CHASSAGNON ET AL.: "Polarisation des gaz; un système d'étude automatique piloté par calculateur"**

(73) Titulaire : **COMMISSARIAT A L'ENERGIE ATOMIQUE**
**31-33, rue de la Fédération**
**F-75015 Paris (FR)**

(72) Inventeur : **Chaillout, Jean-Jacques**
**Le Montagnier-Haut**
**F-38960 St Etienne De Crossey (FR)**
Inventeur : **Kernevez, Nelly**
**14 Bld Maréchal Leclerc**
**F-38000 Grenoble (FR)**
Inventeur : **Leger, Jean-Michel**
**51C, rue des Ayguinards**
**F-38240 Meylan (FR)**

(74) Mandataire : **Mongrédien, André et al**
**c/o BREVATOME 25, rue de Ponthieu**
**F-75008 Paris (FR)**

EP 0 461 999 B1

Jouve, 18, rue Saint-Denis, 75001 PARIS

## Description

La présente invention a pour objet un magnétomètre. Elle trouve une application dans la mesure précise des champs magnétiques faibles (typiquement dans la plage de 20 à 70 $\mu$T correspondant aux valeurs du champ magnétique terrestre).

Le magnétomètre de l'invention entre dans la catégorie des magnétomètres dits à résonance, dont on pourra trouver une description générale dans l'article de F. HARTMAN intitulé "Resonance Magnetometers", publié dans la revue "IEEE Transactions on Magnetics", vol. MAG-8, n° 1, March 1972, pp. 66-75.

Un magnétomètre à résonance est un appareil qui, plongé dans un champ magnétique Bo, délivre un signal électrique de fréquence F dont la valeur est liée à Bo par la relation dite de LARMOR :

$$F = \gamma Bo$$

où $\gamma$ est un rapport gyromagnétique (d'un électron ou d'un nucléon selon la substance utilisée). Pour l'électron, par exemple, ce rapport est égal à 28Hz/nT.

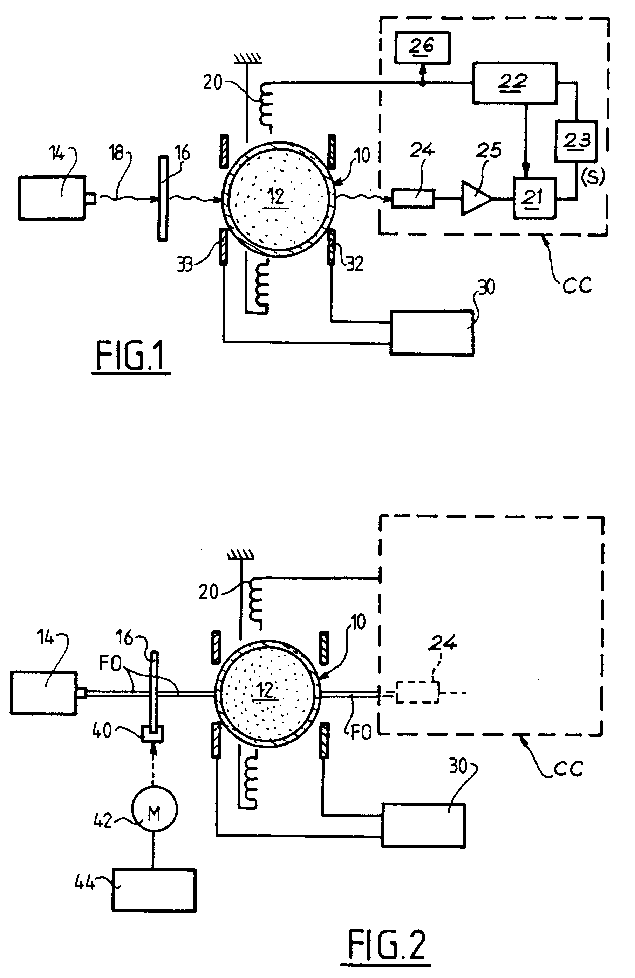

Dans cette classe d'appareils, le magnétomètre à pompage optique occupe une place privilégiée. La constitution générale d'un magnétomètre à pompage optique et à résonance magnétique est représentée schématiquement sur la figure 1.

Une cellule 10, au moins partiellement transparente, est remplie d'un gaz 12, en général de l'hélium (isotope 4) à une pression de 1 à quelques torrs. Une source lumineuse 14 délivre un faisceau lumineux 18 dont la longueur d'onde se situe autour de 1,1 $\mu$m dans le cas de l'hélium. Ce faisceau est convenablement polarisé par un moyen 16 puis injecté dans la cellule 10.

Par ailleurs, une décharge radio-fréquence (dite "faible" ou "douce") est produite dans le gaz par un générateur 30 relié à deux électrodes 32, 33 disposées autour de la cellule 10. Cette décharge produit des atomes dans un état métastable ($2^3S_1$ dans le cas de l'hélium). Le faisceau lumineux incident 18 "pompe" ces atomes à partir de l'état métastable pour les amener dans un autre état excité ($2^3P$).

En présence d'un champ magnétique Bo, les niveaux d'énergie se séparent en sous-niveaux, dits de ZEEMAN. Une résonance radiofréquence entre de tels sous-niveaux peut être établie par un champ radio-fréquence (résonance magnétique) ou par une modulation de la lumière (double résonance optique ; COHEN, TANNOUDJI, Ann. Phys. 7, 1962, p. 423). Dans le cas de l'hélium, isotope 4, la résonance s'établit entre deux sous-niveaux électroniques ZEEMAN de l'état métastable. Cette résonance est mise en évidence par divers moyens électroniques connus de l'homme du métier, dont une variante est représentée sur la figure 1. Il s'agit d'un enroulement 20 disposé de part et d'autre de la cellule 10 (dans une disposition dite de HELMOLTZ), d'un générateur radio-fréquence 22, d'un photodétecteur 24 recevant le rayonnement lumineux ayant traversé la cellule, d'un amplificateur 25, d'une détection synchrone 21 et d'un intégrateur 23. L'ensemble des moyens 21 à 26 sera désigné globalement par la suite par la référence CC. Le générateur 22 alimente l'enroulement 20 en courant à la fréquence F, ce qui crée un champ magnétique oscillant dont une composante entretient la résonance et module en retour le faisceau lumineux ayant traversé la cellule. Cette modulation constitue le signal. Elle est mise en évidence par la détection synchrone en sortie du photodétecteur via l'amplificateur. La référence est donnée par le générateur. La sortie de la détection synchrone correspondant à la composante du signal en phase avec la référence sert de signal d'erreur statique. Ce signal d'erreur réajuste la fréquence F du synthétiseur à la fréquence de LARMOR. Il faut pour cela que le synthétiseur soit pilotable en tension ; il peut également être remplacé par un oscillateur commandé en tension (V.C.O.).

Un signal électrique de résonance S s'établit ainsi dans cette boucle, à la fréquence de LARMOR. Un fréquencemètre 26 en donne la valeur F. Le champ à mesurer Bo s'en déduit par la relation Bo=F/$\gamma$.

Les magnétomètres à hélium de ce type ont d'abord utilisé des lampes à hélium. L'obtention récente de cristaux d'aluminate de lanthane-néodyme (ou LNA) ayant permis de réaliser des lasers accordables autour de la longueur d'onde de 1,083 $\mu$m correspondant précisément à la raie de pompage optique de l'hélium, ce type de laser s'est substitué tout naturellement à ces lampes avec une amélioration sensible des performances, ce qui a donné un regain d'intérêt à ces appareils.

Un tel magnétomètre, équipé d'un laser à LNA, est décrit dans le document FR-A-2 598 518 (ou EP-A-246 146)

Bien que satisfaisants à certains égards, ces magnétomètres présentent cependant des inconvénients. En effet, par principe, ils sont fortement anisotropes, et ceci à la fois en amplitude et en fréquence. Des extinctions de signal se produisent pour certaines orientations du champ magnétique à mesurer. Ces orientations défavorables correspondantes soit à certaines directions de propagation du faisceau lumineux (dans le cas d'une polarisation circulaire) soit à certaines directions de polarisation (dans le cas d'une polarisation rectiligne). Le pompage optique ne produit plus alors la polarisation requise des sous-niveaux ZEEMAN des atomes, ou la détection de la résonance se révèle inefficace.

Diverses solutions ont été proposées pour remédier à cet inconvénient. La Société américaine Texas Instruments, par exemple, préconise l'utilisation de plusieurs cellules orientées de telle sorte que l'une au moins fournisse un signal exploitable. La Société canadienne Canadian Aviation Electronics préconise plutôt d'orienter convenablement le magnétomètre par rapport au champ à mesurer.

Les zones d'extinction du signal étant plus étendues pour un faisceau polarisé rectilignement que pour un faisceau polarisé circulairement, on pourrait préférer travailler en polarisation circulaire. Cependant, avec ce type de polarisation, un phénomène de déplacement de fréquence se produit, du fait du pompage optique, qui provoque des erreurs de mesure.

Le magnétomètre de l'invention utilise donc une polarisation rectiligne pour éviter cette erreur. Mais les inconvénients liés à cette polarisation demeurent et les solutions proposées, qui reviennent à multiplier le nombre d'appareils, restent peu satisfaisantes : encombrement excessif, nécessité d'équilibrer les diverses voies de mesure, commande de l'orientation des cellules, consommation électrique élevée, etc.... Par ailleurs, toute l'installation doit être réalisée dans un environnement amagnétique, ce qui pose de redoutables problèmes technologiques.

La présente invention a justement pour but de remédier à ces inconvénients. A cette fin, elle propose un magnétomètre à résonance et à pompage optique dont l'isotropie est excellente tout en restant simple de construction et peu encombrant (il ne comprend qu'une seule cellule).

Ce but est atteint par l'invention grâce à l'utilisation de moyens permettant de faire tourner la direction de polarisation rectiligne du faisceau injecté dans la cellule, pour lui donner la direction optimale correspondant à une amplitude maximale du signal de résonance.

Plusieurs moyens peuvent être utilisés pour déterminer et obtenir cette direction optimale. Dans une première variante, le magnétomètre comprend un magnétomètre directionnel (comme par exemple un ensemble de trois "flux-gates" ou un magnétomètre à RPE (Résonance Paramagnétique Electronique) donnant des informations sur la direction du champ ambiant Bo à mesurer. Un circuit de traitement de ces informations calcule l'orientation optimale de polarisation correspondant à cette direction du champ ambiant et commande la rotation de la polarisation en conséquence.

Dans une deuxième variante, le magnétomètre comprend des moyens pour moduler à basse fréquence la direction de polarisation et pour effectuer une détection synchrone du signal de résonance. Le signal détecté sert de signal d'erreur pour corriger la polarisation et lui donner la direction optimale.

Dans une troisième variante concernant seulement un magnétomètre à résonance magnétique, on utilise un artifice consistant à disposer plusieurs enroulements d'excitation d'axes différents autour de la cellule, ce qui permet d'obtenir plusieurs signaux de détection et de recueillir, en conséquence, des informations sur l'orientation du champ ambiant par rapport aux axes des enroulements. Il est alors encore possible d'orienter la polarisation pour lui donner la direction optimale.

Toutes ces dispositions s'appliquent aux magnétomètres à résonance et à pompage optique quel que soit le milieu pompé. Naturellement, dans l'état actuel de la technique, l'hélium joue un rôle privilégié. Mais d'autres gaz ou fluides connus ou à venir ne sont pas exclus pour autant de l'invention, comme les vapeurs de métaux alcalins (césium, rubidium, etc...). La résonance peut être magnétique (excitation par un champ RF) ou optique (modulation de la lumière, multirésonance optique).

De même, si le laser à LNA joue un rôle privilégié dans le pompage des cellules à hélium, l'invention ne se limite pas à cette source et tout magnétomètre utilisant une source lumineuse quelconque fait partie de l'invention, dès lors qu'il travaille avec un faisceau à polarisation asservie.

De toute façon, les caractéristiques et avantages de l'invention apparaîtront mieux à la lumière de la description qui va suivre. Cette description porte sur des exemples de réalisation, donnés à titre explicatif et non limitatif. Elle se réfère par ailleurs à des dessins annexés sur lesquels :

- la figure 1, déjà décrite, montre un magnétomètre selon l'art antérieur ;
- la figure 2 montre un schéma général d'un magnétomètre selon l'invention ;
- la figure 3 montre un mode de réalisation utilisant un magnétomètre directionnel ;
- la figure 4 montre un mode de réalisation de l'asservissement avec modulation et détection synchrone ;
- la figure 5 illustre le principe de cet asservissement ;
- la figure 6 montre une variante à enroulements multiples.

Le magnétomètre représenté sur la figure 2 comprend tout d'abord des moyens déjà représentés sur la figure 1 et qui portent, pour cette raison, les mêmes références numériques. Il s'agit de la cellule 10 remplie d'hélium, du laser 14, du polariseur rectiligne 16, de l'enroulement 20, des moyens CC (comprenant le circuit d'excitation de la résonance 22, le moyen de détection 24, le fréquencemètre 26, l'amplificateur 25, la détection synchrone 21 et l'intégrateur 23) et du générateur de décharge 30. Selon l'invention, le polariseur 16 peut être modifié en direction. Dans la variante illustrée, ce polariseur repose sur un support orientable 40, commandé en rotation par un moteur 42. Des moyens 44 sont prévus pour commander le moteur.

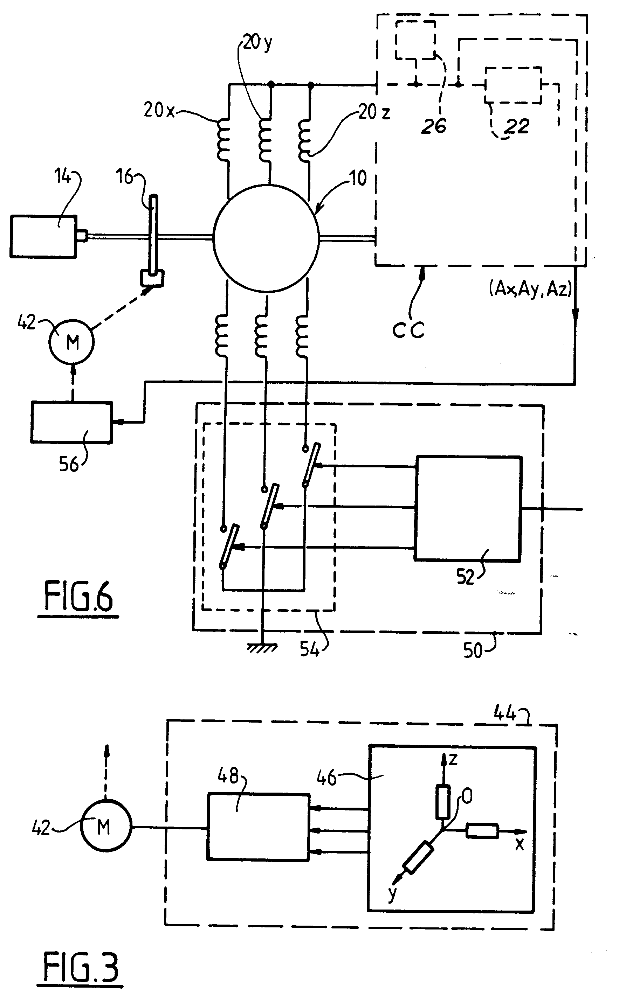

Diverses variantes sont prévues pour réaliser ces moyens 44. Dans la variante illustrée sur la figure 3, ces moyens comprennent un magnétomètre directionnel 46 donnant des informations sur la direction du champ ambiant Bo par rapport à trois axes Ox, Oy, Oz. Un circuit 48 traite ces informations et calcule l'orientation optimale de la direction de polarisation correspondant à cette direction du champ ambiant. Il commande la rotation du moteur 42 pour donner au polariseur cette direction optimale.

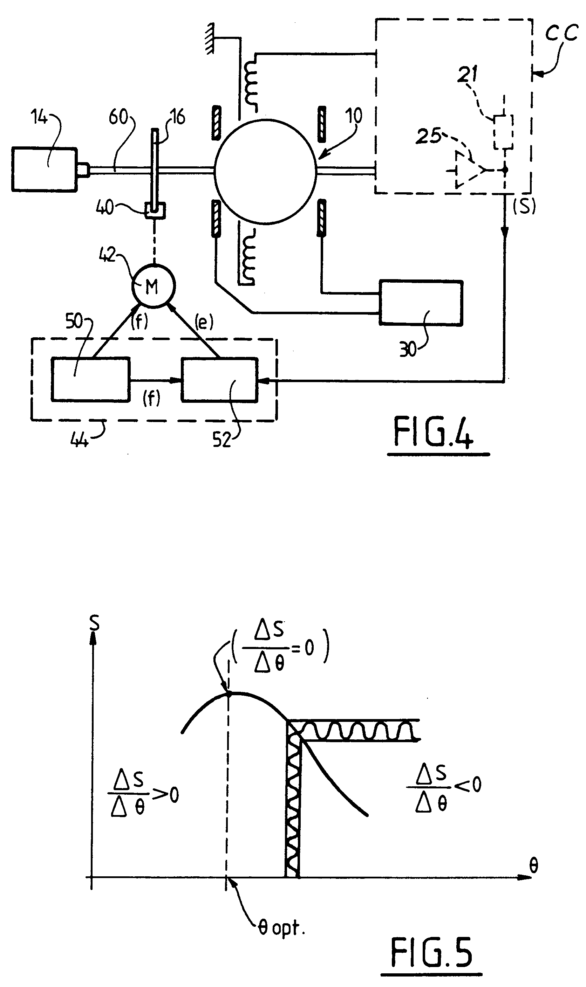

Dans la variante illustrée sur la figure 4, les moyens de commande 44 du moteur 42 comprennent :

- un générateur 50 délivrant au moteur un signal à une basse fréquence f, ce signal ayant pour effet de moduler l'angle d'orientation du polariseur 16,
- un circuit de détection synchrone 52 recevant le signal de résonance dont l'amplitude est modulée à la fréquence f et un signal de référence à cette même fréquence f délivré par le générateur 50.

Le circuit de détection synchrone 52 délivre un signal $\underline{e}$ constituant un signal d'erreur, lequel signal d'erreur est appliqué au moteur 42 dans un sens tel que la rotation du moteur tende à annuler le signal d'erreur.

La figure 5 illustre le fonctionnement de cette chaîne d'asservissement. La modulation de l'angle $\theta$ de la polarisation entraîne une modulation de l'amplitude du signal de résonance S. Le rapport $\Delta S/\Delta\theta$ (en grandeur et en signe) entre l'amplitude $\Delta S$ de modulation du signal S et l'amplitude $\Delta\theta$ la modulation angulaire permet de situer le point de fonctionnement du magnétomètre par rapport à l'orientation optimale $\theta$opt de la direction de polarisation. Ce rapport est nul si l'orientation est optimale, négatif au-delà, positif en deçà. Ce rapport, ou tout autre grandeur équivalente, peut donc être pris comme signal d'erreur. Il doit être appliqué au moteur dans un sens tel que la rotation du moteur qui s'ensuit annule le signal d'erreur.

Dans une autre variante, illustrée sur la figure 6, on utilise une disposition décrite -mais utilisée dans un autre but-dans la demande de brevet français déposée simultanément par le présent demandeur pour "Magnétomètre à résonance magnétique et à enroulements d'excitation multiplexés". Cette disposition consiste à munir la cellule 10 de trois enroulements d'excitation 20x, 20y, 20z, disposés autour de la cellule 10 avec des axes non parallèles entre eux (par exemple en trièdre trirectangle), ces enroulements étant mis en service séquentiellement par un multiplexeur 50. La fréquence du signal de résonance prend alors successivement trois valeurs Ax, Ay, Az. Le multiplexeur comprend un générateur 52 et un commutateur 54 à 3 interrupteurs reliés aux trois enroulements.

L'utilisation de plusieurs enroulements multiplexés permet d'obtenir plusieurs signaux de résonance dont les fréquences respectives dépendent des orientations relatives du champ ambiant par rapport aux axes des enroulements. La connaissance de ces fréquences permet de déterminer l'orientation du champ. A cet égard, on pourra consulter l'article de COHEN-TANNOUDJI publié dans les Annales de Physique 7, 1962, pp. 423-429 et qui donne l'amplitude du signal en fonction des angles relatifs entre la polarisation et le champ. La direction optimale de la polarisation s'en déduit. C'est le rôle du circuit de calcul 56, qui délivre finalement le signal de commande approprié au moteur 42.

Dans toutes ces variantes, le faisceau lumineux peut être guidé entre la source 14 et la cellule 10, d'une part, et entre la cellule 10 et le photorécepteur 24, d'autre part, par une fibre optique F0.

**Revendications**

1. Magnétomètre à résonance et à pompage optique comprenant une cellule (10) remplie d'un gaz (12) dont les atomes présentent un rapport gyromagnétique $\gamma$, une source lumineuse (14) émettant un faisceau lumineux (18), un polariseur rectiligne (16) traversé par ce faisceau, le faisceau ayant traversé le polariseur (16) étant injecté dans la cellule (10) et étant apte à y pomper optiquement le gaz, des moyens de prélèvement et de détection (20 à 25) d'un signal électrique de résonance (S) à une fréquence de LARMOR F=$\gamma$Bo où Bo est un champ magnétique ambiant dans lequel plonge la cellule (10) et qui est le champ à mesurer, un moyen (26) pour mesurer cette fréquence, l'amplitude du champ magnétique ambiant se déduisant de la fréquence F par la relation Bo=F/$\gamma$, ce magnétomètre étant caractérisé par le fait qu'il comprend en outre des moyens (40, 42, 44, 46) pour faire tourner la direction de polarisation rectiligne du faisceau injecté dans la cellule et lui donner la direction optimale correspondant à une amplitude maximale du signal de résonance (S).

2. Magnétomètre selon la revendication 1, caractérisé par le fait que les moyens pour faire tourner la direction de polarisation comprennent un support orientable (40) sur lequel repose le polariseur, un moteur (42) agissant sur ce support, et des moyens (44) de commande du moteur (42).

3. Magnétomètre selon la revendication 2, caractérisé par le fait que les moyens de commande (44) du moteur (42) comprennent un magnétomètre directionnel (46) donnant des informations sur la direction du champ ambiant Bo, un circuit (48) de traitement de ces informations apte à calculer l'orientation optimale de la direction de polarisation correspondant à cette direction du champ ambiant et à commander la rotation du moteur (42) pour donner au polariseur cette direction optimale.

4. Magnétomètre selon la revendication 2, caractérisé par le fait que les moyens de commande (44)

du moteur (42) comprennent :

- un générateur (50) délivrant au moteur (42) un signal basse fréquence (f), ayant pour effet de moduler l'angle θ d'orientation du polariseur (16),
- un circuit de détection synchrone (52) recevant le signal de résonance (S) modulé à la fréquence f et un signal de référence à la fréquence f délivré par le générateur basse fréquence (44), ce circuit de détection synchrone (52) délivrant un signal (e) constituant un signal d'erreur, lequel signal d'erreur est appliqué au moteur (42) dans un sens tel que la rotation du moteur tende à annuler le signal d'erreur.

5. Magnétomètre selon la revendication 2, caractérisé par le fait que les moyens de commande (44) du moteur (42) comprennent :

- plusieurs enroulements de détection (20x, 20y, 20z) disposés autour de la cellule (10) avec des axes de directions différentes, ces enroulements étant mis en service séquentiellement par un multiplexeur (50), la fréquence du signal de résonance prenant successivement autant de valeurs (Ax, Ay, Az) qu'il y a d'enroulements,
- un circuit de traitement (56) apte à calculer, en fonction des différentes fréquences (Ax, Ay, Az) du signal de résonance, l'orientation du champ ambiant Bo, à déterminer l'orientation optimale de la polarisation rectiligne correspondant à ce champ ambiant et à appliquer au moteur (42) la tension de commande apte à orienter le polariseur (16) pour lui donner cette valeur optimale.

6. Magnétomètre selon l'une quelconque des revendications 1 à 5, caractérisé par le fait que le gaz (12) de la cellule (10) est de l'hélium.

7. Magnétomètre selon la revendication 6, caractérisé par le fait qu'il comprend en outre des moyens (30, 32, 33) pour créer une décharge haute fréquence dans la cellule à hélium (10).

8. Magnétomètre selon l'une quelconque des revendications 1 à 7, caractérisé par le fait que la source lumineuse (14) est un laser.

9. Magnétomètre selon l'une quelconque des revendications 1 à 8, caractérisé par le fait que le faisceau lumineux est guidé entre la source (14) et la cellule (10), d'une part, et entre la cellule (10) et un photorécepteur (24), d'autre part, par une fibre optique (F0).

**Patentansprüche**

1. Optisch gepumpter Resonanzmagnetometer, der eine Zelle (10), die mit einem Gas (12) gefüllt ist, dessen Atome ein gyromagnetisches Verhältnis γ aufweisen, eine Lichtquelle (14), welche einen Lichtstrahl (18) aussendet, einen geradlinigen Polarisator (16), der von dem Strahl durchlaufen wird, wobei der Strahl, wenn er den Polarisator (16) durchlaufen hat, in die Zelle (10) eingeführt wird und dazu fähig ist, dort optisch das Gas zu pumpen, Geräte zur Abnahme und zur Detektion (20 bis 25) eines elektrischen Resonanzsignals (S) mit einer LARMOR-Frequenz F=γBo, wobei Bo ein umgebendes Magnetfeld ist, in welches die Zelle (10) eintaucht und welches das zu messende Feld ist, ein Gerät (26) umfaßt, um diese Frequenz zu messen, wobei sich die Frequenz des umgebenden Magnetfeldes sich aus der Frequenz F durch die Beziehung Bo=F/γ ableitet, dieses Magnetometer wird dadurch gekennzeichnet, daß es außerdem Geräte (40, 42, 44, 46) umfaßt, um die geradlinige Polaristationsrichtung des in die Zelle eingeführten Strahls drehen läßt und ihm die einer maximalen Amplitude des Resonanzsignals (S) entsprechende optimale Richtung gibt.

2. Magnetometer gemäß Anspruch 1, dadurch gekennzeichnet, daß die Geräte, um die Polarisationsrichtung drehen zu lassen, eine ausrichtbare Stütze (40), auf welcher der Polarisator ruht, einen treibenden Motor (42) auf dieser Stütze, und Geräte (44) zur Steuerung des Motors (42) umfassen.

3. Magnetometer gemäß Anspruch 2, dadurch gekennzeichnet, daß die Geräte zur Steuerung (44) des Motors (42) ein Richtungsmagnetometer (46) umfassen, welches Informationen über die Richtung des umgebenden Feldes Bo gibt, eine Schaltung (48) zur Verarbeitung dieser Informationen, die fähig ist, die optimale Ausrichtung der Polarisationsrichtung entsprechend dieser Richtung des umgebenden Feldes zu berechnen und die Rotation des Motors (42) zu steuern, um dem Polarisator diese optimale Richtung zu geben.

4. Magnetometer gemäß Anspruch 2, dadurch gekennzeichnet, daß die Geräte zur Steuerung (44) des Motors (42):

- einen Generator (50) umfassen, der dem Motor (42) ein Tieffrequenzsignal (f) liefert, was bewirkt, den Orientierungswinkel Θ des Polarisators (16) zu modulieren,
- eine Schaltung zur synchronen Detektion (52) umfassen, die das mit der Frequenz f modulierte Resonanzsignal (S) und ein von dem Tieffrequenzgenerator (44) geliefertes Referenzsignal mit der Frequenz f empfängt, wobei diese Schaltung zur synchronen Detektion (52) ein Signal (e) liefert, welches ein Fehlersignal bildet, wobei dieses Fehlersignal am Motor (42) so angewendet wird, daß die Rotation des Motors danach strebt, das Fehlersignal aufzuheben.

5. Magnetometer gemäß Anspruch 2, dadurch gekennzeichnet, daß die Geräte zur Steuerung (44) des Motors (42):
   - mehrere Detektorspulen (20x, 20y, 20z) umfassen, die rund um die Zelle (10) mit verschiedenen Detektionsachsen angeordnet sind, wobei diese Spulen aufeinanderfolgend durch einen Multiplexer (50) eingesetzt werden, und die Frequenz des Resonanzsignals nacheinander ebenso-viele Werte (Ax, Ay, Az) einnimmt, wie es Spulen gibt,
   - eine Schaltung zur Verarbeitung (56) umfassen, die dazu fähig ist, in Abhängigkeit von verschiedenen Frequenzen (Ax, Ay, Az) des Resonanzsignals die Ausrichtung des umgebenden Feldes Bo zu berechnen, die optimale Ausrichtung der geradlinigen Polarisation entsprechend diesem umgebenden Feld zu bestimmen und am Motor (42) die Steuerspannung anzulegen, die dazu dient, den Polarisator (16) auszurichten, um ihm diesen optimalen Wert zu geben.

6. Magnetometer gemäß einem der Ansprüche 1 bis 5, dadurch gekennzeichnet, daß das Gas (12) der Zelle (10) Helium ist.

7. Magnetometer gemäß Anspruch 6, dadurch gekennzeichnet, daß es außerdem Geräte (30, 32, 33) umfaßt um eine Hochfrequenzentladung in der Heliumzelle (10) zu erzeugen.

8. Magnetometer gemäß einem der Ansprüche 1 bis 7, dadurch gekennzeichnet, daß die Lichtquelle (14) ein Laser ist.

9. Magnetometer gemäß einem der Ansprüche 1 bis 8, dadurch gekennzeichnet, daß der Lichtstrahl einerseits zwischen der Quelle (14) und der Zelle (10) und andererseits zwischen der Zelle (10) und einem Photorezeptor (24) durch eine Lichtfaser geleitet wird.

**Claims**

1. Optical pumping, resonance magnetometer incorporating a cell (10) filled with a gas (12), whose atoms have a gyromagnetic ratio $\gamma$, a light source (14) emitting a light beam (18), a linear polarizer (16) traversed by the said beam, the beam having traversed the polarizer (16) is injected into the cell (10) and is able to optically pump there the gas, sampling and detection means (20 to 25) for an electric resonance signal (S) at a Larmor frequency $F = \gamma Bo$, in which Bo is an ambient magnetic field in which is immersed the cell (10) and which is the field to be measured, a means (26) for measuring the said frequency, the amplitude of the ambient magnetic field being deduced from the frequency F by the relation $Bo = F/\gamma$ said magnetometer being characterized in that it also comprises means (40,42,44,46) for rotating the linear polarization direction of the beam injected into the cell and for giving it the optimum direction corresponding to a maximum amplitude of the resonance signal (S).

2. Magnetometer according to claim 1, characterized in that the means for rotating the polarization direction incorporate an orientable support (40), on which rests the polarizer, a motor (42) acting on the said support and control means (44) for the said motor (42).

3. Magnetometer according to claim 2, characterized in that the control means (44) of the motor (42) incorporate a directional magnetometer (46) giving information on the direction of the ambient field Bo, a circuit (48) for processing said information able to calculate the optimum orientation of the polarization direction corresponding to said direction of the ambient field and for controlling the rotation of the motor (42) in order to give said optimum direction to the polarizer.

4. Magnetometer according to claim 2, characterized in that the control means (44) for the motor (42) comprise:
   a generator (50) supplying the motor (42) with a low frequency signal (f) having the effect of modulating the orientation angle $\theta$ of the polarizer (16),
   a synchronous detection circuit (52) receiving the resonance signal (S) modulated at frequency f and a reference signal at the frequency f supplied by the low frequency generator (44), said synchronous detection circuit (52) supplying a signal (e) constituting an error signal, which is applied to the motor (42) in a sense such that the rotation of the motor tends to cancel out the error signal.

5. Magnetometer according to claim 2, characterized in that the control means (44) of the motor (42) comprise:

several detection windings (20x,20y,20z) arranged around the cell (10) with axes having different directions, said windings being sequentially put into service by a multiplexer (50), the frequency of the resonance signal assuming successively the same number of values (Ax,Ay,Az) as there are windings,

a processing circuit (56) able to calculate, as a function of the different frequencies (Ax,Ay,Az) of the resonance signal, the orientation of the ambient field Bo, to determine the optimum orientation of the linear polarization corresponding to said ambient field and to apply to the motor (42) the control voltage able to orient the polarizer (16) in order to give it the said optimum value.

6. Magnetometer according to any one of the claims 1 to 5, characterized in that the gas (12) of the cell (10) is helium.

7. Magnetometer according to claim 6, characterized in that it also comprises means (30,32,33) for creating a high frequency discharge in the helium cell (10).

8. Magnetometer according to any one of the claims 1 to 7, characterized in that the light source (14) is a laser.

9. Magnetometer according to any one of the claims 1 to 8, characterized in that the light beam is guided between the source (14) and the cell (10) on the one hand and between the cell (10) and a photoreceiver (24) on the other by an optical fibre (F0).

FIG.1

FIG.2

FIG.6

FIG.3

FIG.4

$$\left(\frac{\Delta S}{\Delta \theta}=0\right)$$

$$\frac{\Delta S}{\Delta \theta}>0$$

$$\frac{\Delta S}{\Delta \theta}<0$$

θ opt.

FIG.5